# FASCICULE DE BREVET EUROPEEN

(11) **EP 0 769 778 B1**
(45) Date de publication et mention de la délivrance du brevet: **14.01.2004**
(21) Numéro de dépôt: 96402133.1
(22) Date de dépôt: 08.10.1996
(51) Int. Cl.: G11B 7/12, H01S 5/02, G11B 7/135, G11B 7/09

(54) **Dispositif émetteur-récepteur de lumière et système lecture optique**
Lichtemittierende/-empfangende Vorrichtung und optisches System
Light emitter/receiver device and optical system

(30) Priorité: 17.10.1995 FR 9512147
(43) Date de publication de la demande: 23.04.1997
(73) Titulaire: Thales, 75008 Paris (FR)
(72) Inventeur: Lehureau, Jean-Claude, 92402 Courbevoie Cedex (FR); Renaud, Jean-Charles, 92402 Courbevoie Cedex (FR)

(56) Documents cités:
- EP-A- 0 452 793
- EP-A- 0 555 097
- EP-A- 0 627 733
- EP-A- 0 671 734
- GB-A- 2 274 740
- XEROX DISCLOSURE JOURNAL, vol. 7, no. 4, Juillet 1982 - Août 1982, pages 237-238, XP002008868 SCIFRES, STREIFER & BURNHAM: "Diode Laser for both Transmitting and Receiving Optical Signals"

## Description

L'invention concerne un dispositif émetteur-récepteur de lumière et son application à un système de lecture optique d'un support d'enregistrement.

L'invention est application notamment à la lecture de disques optiques et concerne le système optique de lecture appelé dans la technique "pick up" optique.

Un pick-up optique est constitué d'une partie aval regroupant :
- l'optique de focalisation et les actuateurs permettant de déplacer cette optique de manière à suivre radialement et en focalisation la piste en cours de lecture ;
- d'une partie amont regroupant les sources lasers d'écriture lecture ;
- au moins un séparateur permettant de rediriger le faisceau de retour sur les détecteurs ;
- des moyens optiques d'occultation ou de déformation du faisceau permettant au détecteurs d'extraire les signaux de lecture, d'erreur de focalisation et d'erreur de suivi de piste.

Le ou les composants lasers sont généralement réalisés sur un substrat d'arséniure de gallium, tandis que les détecteurs sont réalisés sur un substrat de silicium.

L'invention concerne tout d'abord la partie amont du pick-up, elle diminue le nombre de composants et simplifie l'opération d'ajustage en intégrant la fonction détecteur sur la puce laser.

Il est par ailleurs connu qu'un composant réalisé sur un substrat d'arséniure de gallium peut constituer un détecteur ; dans le domaine des télécommunications, cette propriété a été utilisée pour réaliser des communications bidirectionnelles alternées (half duplex) ; la diode laser est polarisée alors soit en direct de manière à émettre, soit en inverse de manière à fournir un photocourant proportionnel à la lumière reçue. Dans le domaine des pick up de lecture optique, il a été proposé de mettre à profit le fait que la lumière réfléchie sur un disque est refocalisée exactement sur la source pour lire l'information par modification du courant induit dans le laser. Ce procédé n'a jamais permis de réaliser des systèmes véritablement opérationnels car la qualité du signal en polarisation directe est insuffisante et car aucun moyen ne permettait d'extraire les signaux de focalisation et de suivi de piste.

L'invention concerne donc un dispositif émetteur-récepteur de lumière comprenant un empilement de couches de matériaux semiconducteurs comportant de part et d'autre de l'empilement, une première et une deuxième électrodes d'injection de courant permettant de faire fonctionner l'empilement de couches en mode laser et émettant un faisceau lumineux par une tranche de l'empilement, une des électrodes ayant la forme d'un ruban, caractérisé en ce qu'il comporte au moins une première électrode de détection disposée au bord de ladite tranche, pemettant de faire fonctionner l'empilement en mode photodétecteur en coopération avec une deuxième électrode de détection disposée de l'autre côté de l'empilement, ainsi que des moyens de guidage latéral de la lumière dans les zones situées sous l'électrode de détection et sous l'électrode en forme de ruban ainsi que des moyens de découplage optique et d'isolation électrique des zones de l'empilement situées sous les deux électrodes.

L'invention concerne également un système de lecture optique d'un support d'enregistrement, caractérisé en ce qu'il comporte un dispositif émetteur-récepteur, de telle façon que le dispositif émetteur-récepteur puisse émettre de la lumière vers un support d'enregistrement et que de la lumière réfléchie par celui-ci soit transmise à au moins l'un des détecteurs.

Ce système comporte un réseau de diffraction destiné à être situé entre le dispositif émetteur-récepteur et le support d'enregistrement, transmettant la lumière qu'il reçoit du laser vers le support d'enregistrement et défléchissant la lumière qu'il reçoit du support d'enregistrement vers l'un au moins des détecteurs.

Plus particulièrement, le réseau de diffraction est sensiblement linéaire et ne donne lieu qu'à des ordres de diffraction d'un même signe (positifs par exemple).

Les différents objets et caractéristiques de l'invention apparaîtront plus clairement dans la description qui va suivre et dans les figures annexées qui représentent :
- la figure 1, un système de lecture optique de support d'enregistrement connu dans la technique ;
- les figures 2a et 2b, des dispositifs émetteurs-récepteurs de lumière selon l'invention ;
- la figure 3, un système de lecture optique de support d'enregistrement selon l'invention ;
- les figures 4a à 4c, un exemple de réalisation d'un réseau applicable dans le système de la figure 3 ;
- la figure 5a, un exemple de réalisation d'un système selon l'invention permettant un réglage de focalisation et un suivi de pistes d'informations ;
- la figure 5b, un système prévoyant un circuit d'exploitation des signaux fournis par les détecteurs DET1 et DET2 ;
- les figures 6a à 6g, des figures illustrant le fonctionnement du système de l'invention et les positions des détecteurs DET1, DET2 ;
- la figure 7, un exemple de circuits de traitement des signaux fournis par les détecteurs DET1, DET2 ;
- la figure 8, un exemple de signaux expérimentaux obtenus.

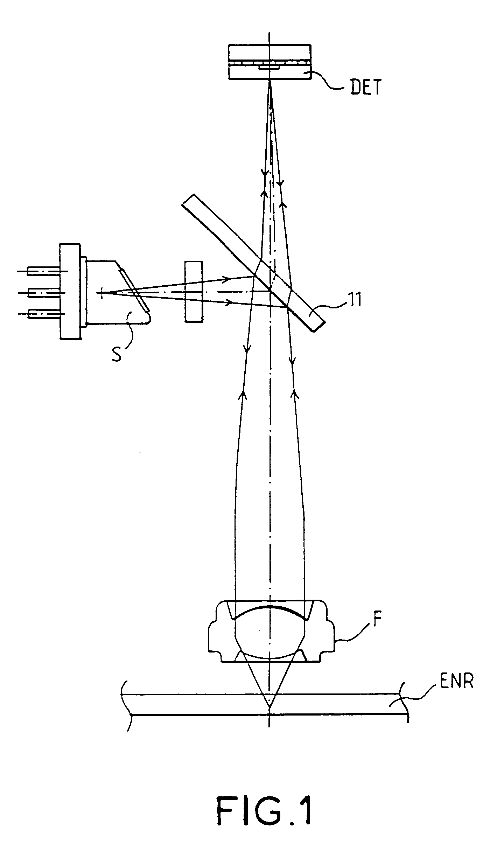

La figure 1 représente un pick up optique suivant un des modes de réalisation le plus communément utilisé :

Le faisceau issu de la source optique S est transmis par un séparateur de faisceau M et une optique de focalisation F au support d'enregistrement à lire ENR. Celui-ci réfléchit le faisceau vers le séparateur de faisceau M qui en retransmet une partie à un détecteur DET. Il est à noter, qu'au retour, la traversée 6 du séparateur M peut induire au faisceau un certain astigmatisme qui sera mis à profit pour extraire un signal d'erreur de focalisation.

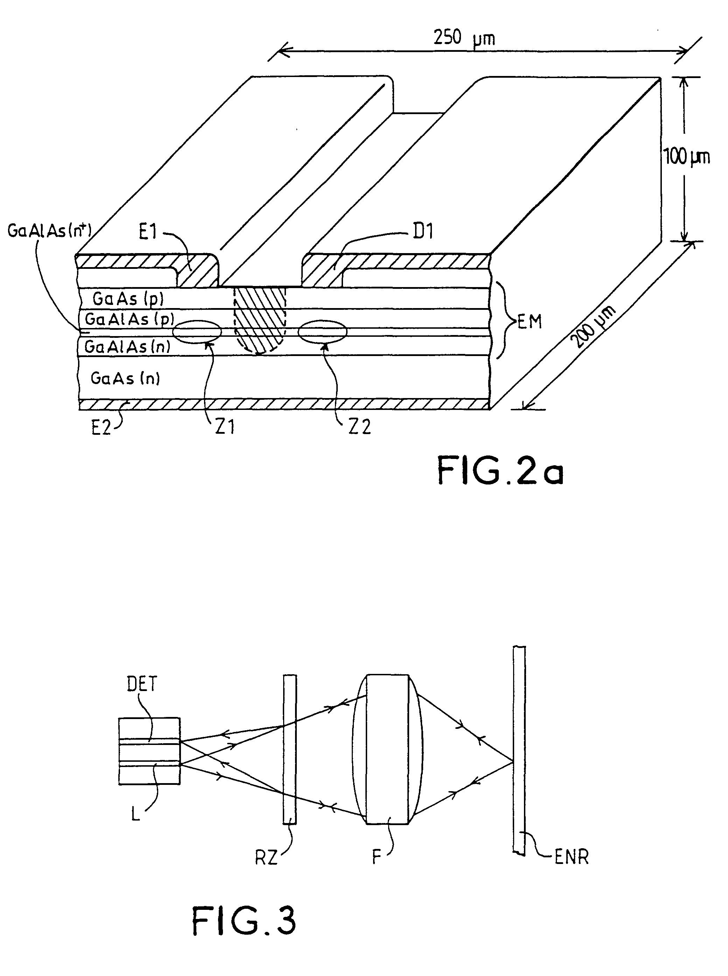

La figure 2a représente un exemple de réalisation d'un dispositif émetteur-récepteur selon l'invention. Ce dispositif comporte un empilement de couches EM de matériaux semiconducteurs formant un laser à semiconducteurs. Par exemple, il comporte sur un substrat en GaAs, une couche de confinement en GaAlAs dopée n, une couche active en GaAlAs dopée n, une autre couche de confinement en GaAlAs dopée p et une couche de contact en GaAs dopée p. De part et d'autre, des électrodes E1 et E2 permettent d'injecter un courant d'excitation dans l'empilement. L'électrode E1 à la forme d'un ruban. Sous ce ruban, des moyens de guidage permettent de guider la lumière parallèlement à ce ruban. Ces moyens de guidage peuvent prendre la forme d'une implantation de protons dans au moins la couche de confinement supérieure de part et d'autre de la zone guidée. Selon une autre technique, la couche active peut être gravée par microlithographie. Les faces du dispositif perpendiculaires à la direction du guide sont clivées. Le laser émet de la lumière selon la zone Z1.

Selon l'invention, on prévoit une électrode D1 disposée à côté de l'électrode E1. Sous l'électrode D1 des moyens de guidage permettent de guider la lumière arrivant sur la zone Z2, dans l'empilement des couches L. Cet empilement est à même de fonctionner en détecteur optique et on détecte un courant entre les électrodes D1 et E2. Des moyens de découplage, tels qu'une zone d'isolation IS, permettent de découpler électriquement et optiquement le laser du détecteur.

De préférence, la zone de contact de l'électrode D1 est plus grande que celle de l'électrode E1. De plus, l'électrode D1 n'a pas forcément la forme d'un ruban.

Selon la figure 2a, l'électrode E2 est commune à la partie laser et à la partie détection, mais il pourrait y avoir deux électrodes séparées. Enfin, l'électrode E2 est représentée sur la face opposée du substrat portant l'empilement EM. Cependant, on pourrait la prévoir sur la face portant l'empilement. Il faudrait alors deux électrodes : une électrode associée à l'empilement du laser et une électrode associée à l'empilement du détecteur.

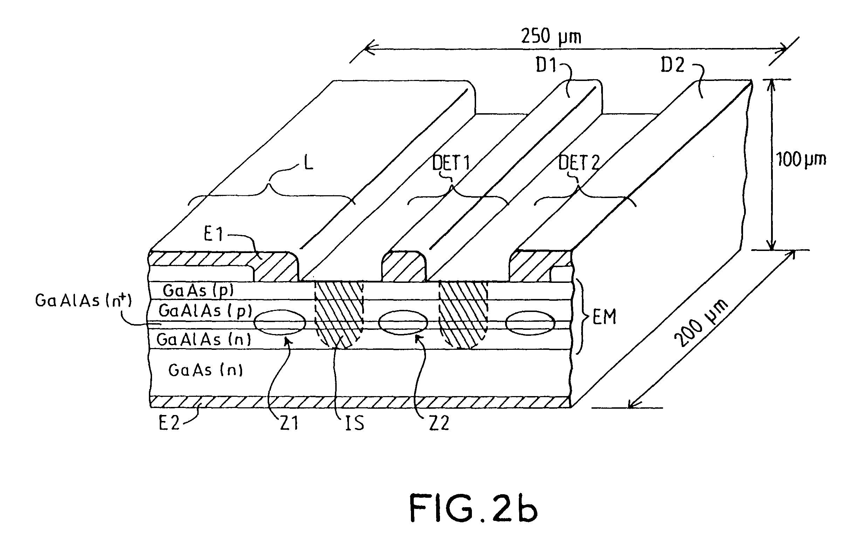

La figure 2b représente un composant comportant un laser L et deux détecteurs DET1 et DET2. Les deux détecteurs selon cet exemple de réalisation sont situés d'un même côté par rapport au laser L. Ils sont isolés électriquement et découplés optiquement l'un de l'autre.

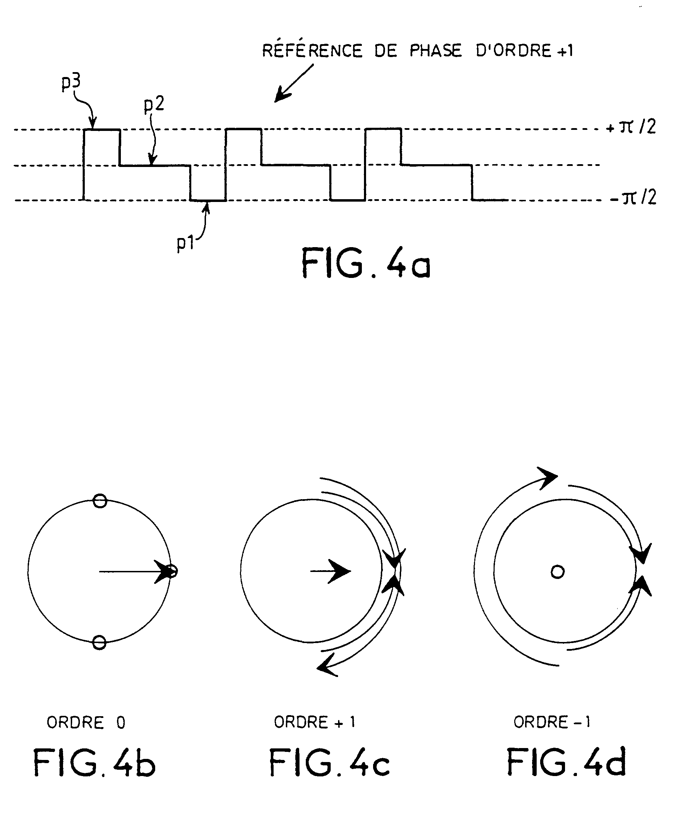

La figure 3 représente un exemple d'application du dispositif de la figure 2 à un système de lecture optique d'un support d'enregistrement. Le dispositif émetteur-récepteur tel que décrit en relation avec la figure 2 est représenté schématiquement à gauche de la figure 3. Le laser L émet un faisceau qui est transmis par un réseau de diffraction RZ à un système optique de focalisation F qui focalise la lumière sur le support d'enregistrement ENR. Celui-ci réfléchit la lumière vers l'optique de focalisation et le réseau RZ. Celui-ci présente la particularité de diffracter la lumière de façon à ne présenter que des ordres de diffraction situés que d'un côté de l'axe optique du système, c'est-à-dire à ne donner lieu qu'à des ordres de diffraction tous du même signe (positifs par exemple). La diffraction d'ordre +1 (par exemple) est ainsi focalisée sur le détecteur DET.

A titre d'exemple le réseau de diffraction peut être réalisé comme représenté en figure 4a. Il présente alors une série de reliefs linéaires dont la section présente trois paliers. Le déphasage entre le palier inférieur p1 (creux des reliefs) et le palier supérieur p3 (crête des reliefs) est sensiblement égale à π radiants pour la lumière à traiter. Pour un réseau en transmission gravé à la surface d'un milieu d'indice 1,5 ceci correspond à une profondeur de gravure égale à la longueur d'onde. Le palier intermédiaire p2 est à mi-distance entre les paliers p1 et p3. Selon l'exemple de la figure 4, les dimensions des paliers p1 et p3 sont égales au quart du pas du réseau et le palier p2 est égal à la moitié du pas du réseau. Le pas du réseau est sensiblement compris entre 5 et 200 pm (aux alentours de quelques dizaines de micromètres).

La figure 4a présente un type de profil de réseau intéressant en ce qu'il peut être réalisé par superposition de deux masques binaires. Les figures 4b à 4d mettent en évidence que ce réseau présente une transmission suivant l'ordre 0 égal à 25 % (ce qui réduit fortement la lumière réfléchie sur le laser) et que l'ordre -1 est strictement nul. Ce réseau diffracte l'essentiel de la lumière non transmise par l'ordre 0 en direction de l'ordre 1, c'est-à-dire vers les cellules.

Il est bien évident qu'un tel réseau peut être également réalisé à l'aide des techniques de l'holographie par interférence de faisceaux lumineux.

Des structures diffractantes en volume (réseau de Bragg) permettent aussi d'obtenir l'élimination de l'ordre -1.

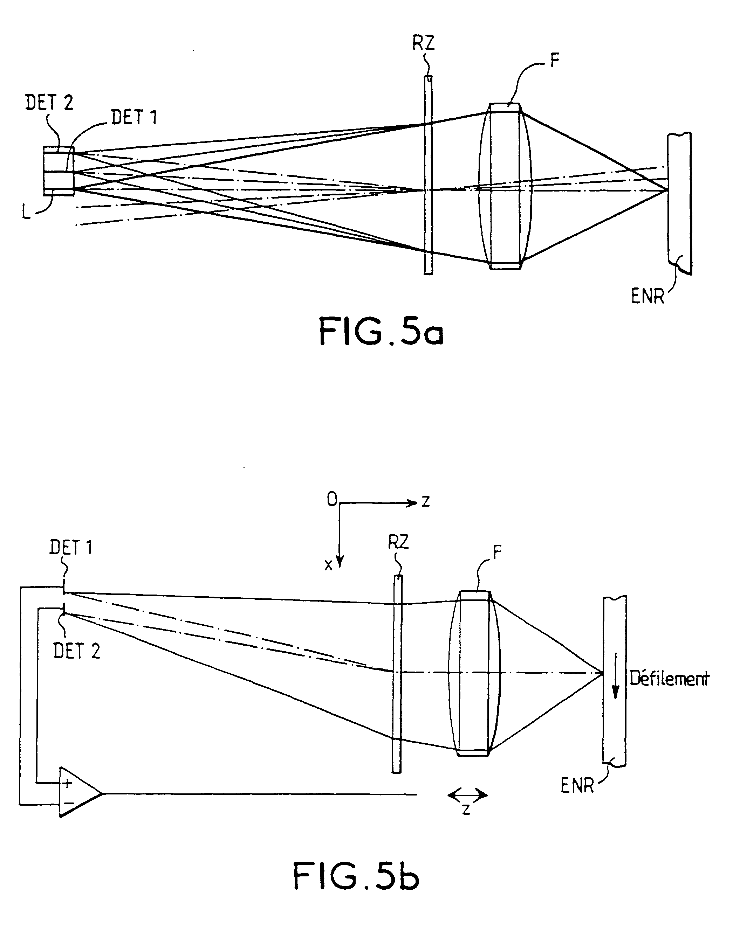

La figure 5a représente un exemple de réalisation dans lequel deux détecteurs sont intégrés sur le même substrat que le laser. Ces détecteurs reçoivent la lumière par la même facette de la puce par laquelle le laser émet. Le composant utilisé peut être du type de celui de la figure 2b. Selon une variante, on peut séparer technologiquement le laser des détecteurs, les détecteurs étant alors réalisés séparément du laser.

Un composant constitué de deux demi-réseaux de pas différents permet de collecter au retour une partie de la lumière réfléchie par le support d'enregistrement et de la rediriger vers chacun des détecteurs. Le profil des réseaux est choisi de manière à annuler tout ordre diffracté dans une direction que nous appellerons arbitrairement ordre -1. Les règles de l'optique veulent que cette dissymétrie entre ordre +1 et -1 se retrouve d'un même côté de l'ordre 0 pour le faisceau incident et le faisceau réfléchi. Dans le plan de la figure 5a, ceci correspondant au fait que la lumière est partiellement défléchi vers le haut de la figure, à l'aller comme au retour. La lumière défléchie à l'aller est réfléchie par le disque (dans le cas où l'angle de déflexion est faible) et réimagée par l'optique sur la facette de la puce AsGa du côté opposé aux détecteurs ; il n'y a pas interférence de ce signal avec le signal principal qui correspond au faisceau non diffracté à l'aller et défléchi vers les détecteurs après réflexion. Cette structure met à profit le fait que, en cas de bonne focalisation, le faisceau non défléchi suit après réflexion exactement le chemin inverse du faisceau incident et vient se focaliser sur la face d'émission ; la déflexion de ce faisceau réfléchi se fait sous un angle faible et le positionnement de l'élément défléchissant est tolérant tant en rotation qu'en translation.

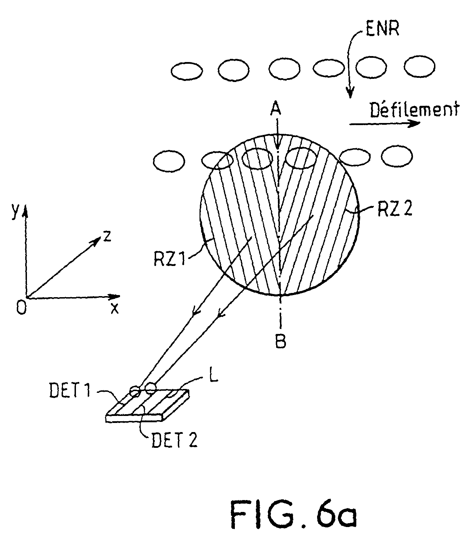

La figure 6a représente une vue en perspective dans lequel le plan du support d'enregistrement ENR est parallèle à un plan xOy. Les deux demi-réseaux RZ1, RZ2 sont parallèles à ce plan. La ligne de séparation AB des deux demi-réseaux RZ1, RZ2 est parallèle à l'axe Oy, lequel est sensiblement perpendiculaire à la direction de lecture des informations sur le support d'enregistrement. La face d'émission du laser L ainsi que les faces de détection des détecteurs DET1 et DET2 sont alignées selon une direction parallèle à Ox (perpendiculaire à Oy).

Selon la figure 5b les signaux des détecteurs sont combinés dans un circuit pour fournir des signaux de réglage de focalisation du faisceau de lecture sur le support d'enregistrement ainsi que des signaux de suivi de la piste d'informations sur le support.

La détection de focalisation est de type asymétrique de façon analogue au dispositif de focalisation décrit dans le brevet français n° 2 325 953. Cependant, dans le présent système le réglage se fait à l'aide des deux faisceaux résultant de la déflexion par les deux demi-réseaux. Ces deux faisceaux correspondent aux deux moitiés de la pupille du système optique de focalisation F.

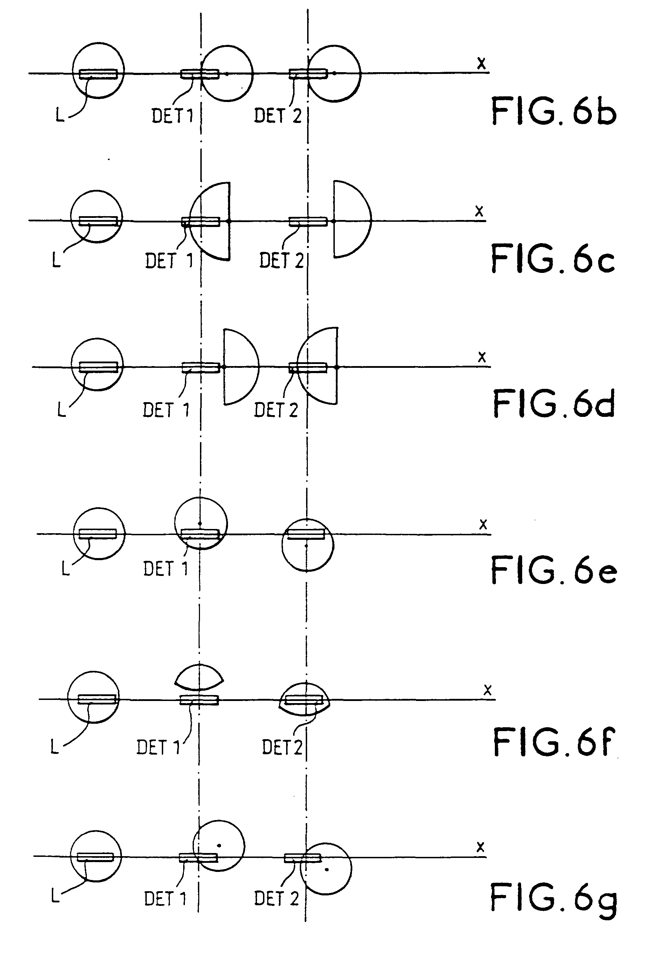

Pour permettre de détecter une défocalisation du système, les détecteurs DET1 et DET2 sont décentrés par rapport à l'axe des faisceaux qu'ils reçoivent lorsque le système est focalisé. Ainsi, la figure 6b représente la face d'émission du laser L et les faces de détection des détecteurs DET1 et DET2. Ces dispositifs sont alignés (selon l'axe Ox sur la figure 6a) : après réflexion par le support d'enregistrement, la lumière est dirigée vers les détecteurs DET1 et DET2 de telle façon que, lorsque le système est focalisé, la lumière fasse sur les détecteurs des spots dont les centres sont décalés latéralement d'un même côté par rapport aux détecteurs DET1 et DET2 (figure 6b). En cas de défocalisation, les faisceaux feront des spots tels qu'un seul détecteur sera éclairé (ou sera plus éclairé que l'autre). En cas d'une défocalisation dans un sens, le détecteur DET1 sera éclairé (figure 6c) et une défocalisation dans l'autre sens donnera lieu à l'éclairement du détecteur DET2 (figure 6d).

Les deux capteurs DET1 et DET2 permettent également de réaliser le suivi radial des pistes d'informations du support d'enregistrement. Pour cela, (voir figure 6e) les centres des spots lumineux, lorsque le système est focalisé sont décalés d'un côté de l'axe Ox pour l'un des détecteurs (vers le haut par exemple pour le détecteur DET1) et de l'autre côté de l'axe Ox pour l'autre détecteur (vers le bas pour le détecteur DET2).

On peut également prévoir une légère oblicité en sens inverses des deux demi-réseaux pour imager les faisceaux légèrement au-dessus ou en-dessous de chaque détecteur. Cette oblicité est représentée sur la figure 6a.

Comme on peut le voir sur la figure 6f, une erreur de suivi de piste radial pourra donner lieu à un éclairement d'un détecteur (DET2 par exemple tandis que l'autre ne sera pas ou sera moins éclairé.

Le réglage de focalisation et le suivi de piste peuvent être réalisés à l'aide des mêmes détecteurs DET1 et DET2. Pour cela, on combine les deux décalages prévus par les figures 6b et 6e de façon à avoir des spots sur les détecteurs DET1 et DET2 comme représenté sur la figure 6g lorsque le système est focalisé, c'est-à-dire d'un même côté des détecteurs selon l'axe x et de part et d'autre des détecteurs selon la perpendiculaire à l'axe x.

Selon une variante de réalisation on peut prévoir que les faces d'émission et de réception du laser et des détecteurs soient alignées selon une direction parallèle à Oy, au lieu d'être perpendiculaires comme cela a été décrit en se reportant à la figure 6a.

Dans ce cas pour régler la focalisation, les centres des spots des faisceaux transmis par les réseaux RZ1 et RZ2, lorsque le système est focalisé, sont décalés d'un même côté par rapport à ligne des détecteurs.

Pour régler le suivi de piste, les centres de ces spots sont décalés parallèlement à l'alignement des détecteurs (direction Oy) en sens opposés par rapport aux détecteurs, c'est-à-dire, par exemple, à droite pour le détecteur DET1 et à gauche pour le détecteur DET2.

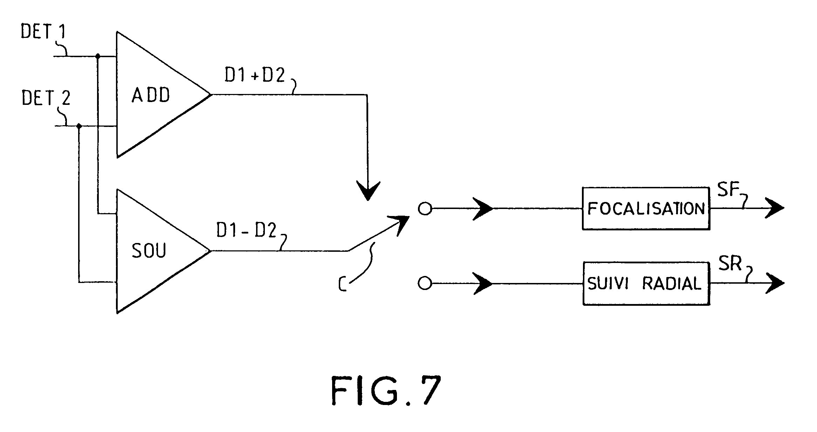

La figure 7 représente un circuit de traitement des signaux fournis par les détecteurs DET1 et DET2. Un circuit ADD fait l'addition D1 + D2 de ces signaux. Un circuit SOU fait la différence D1 - D2 de ces signaux.

Lorsque le signal somme D1 + D2 est supérieur à une valeur de seuil (valeur maximale), cela correspondant dans un disque optique à une réflexion par une zone non gravée du disque, le commutateur C est mis dans une position de façon à connecter le circuit de soustraction SOU vers un circuit de traitement de focalisation. Le circuit de traitement de focalisation reçoit donc la différence D1 - D2 et selon le signe et la valeur D1 - D2, ce circuit fournit un signal de réglage de focalisation SF qui agit sur les dispositifs de réglage de focalisation non représentés.

Lorsque le signal somme D1 + D2 est inférieur à une valeur de seuil, cela correspond à une zone du support d'enregistrement comportant des informations, le commutateur C connecte le circuit SOU à un circuit de réglage radial de suivi de piste. Celui-ci en fonction du signe et de la valeur de D1 - D2, fournit un signal de suivi radial SR qui permet d'agir sur un système de suivi de piste non représenté.

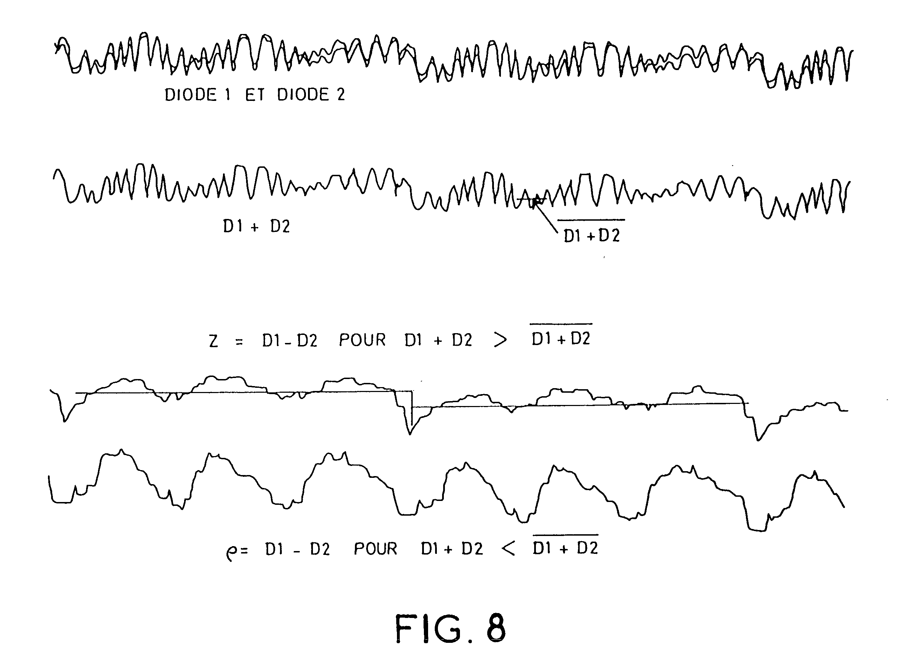

La figure 8 montre les résultats expérimentaux d'extraction de signaux d'erreur radial par la méthode ci-dessus. On constate la forte différence d'amplitude entre la composante d'erreur radial détectée durant les alternances haute et basse du signal somme ; au contraire le signal d'erreur de focalisation est proportionnel à l'amplitude du signal somme et donc typiquement trois fois supérieur lors de l'alternance positive du signal somme.

Il est à noter que la source D1 + D2 des signaux des détecteurs peut être utilisée comme signal de lecture de l'information. Le système de l'invention présente l'avantage d'intégrer les détecteurs DET1 et DET2 dans le même composant que le laser mais également de ne nécessiter que deux détecteurs pour :
- la focalisation ;
- le suivi de piste ;
- la lecture d'informations.

## Revendications

1. Dispositif émetteur-récepteur de lumière comprenant un empilement (EM) de couches de matériaux semiconducteurs comportant de part et d'autre de l'empilement une première et une deuxième électrodes (E1, E2) d'injection de courant permettant de faire fonctionner l'empilement de couches en mode laser et émettant un faisceau lumineux par une tranche de l'empilement, une des électrodes (E1) ayant la forme d'un ruban, **caractérisé en ce qu'**il comporte au moins une première électrode de détection (D1) disposée au bord de ladite tranche, pemettant de faire fonctionner l'empilement en mode photodétecteur en coopération avec une deuxième électrode de détection disposée de l'autre côté de l'empilement (EM), ainsi que des moyens de guidage latéral de la lumière dans les zones situées sous l'électrode de détection (D1) et sous l'électrode en forme de ruban (E1) ainsi que des moyens de découplage optique et d'isolation électrique des zones de l'empilement (EM) situées sous les deux électrodes.

2. Dispositif émetteur-récepteur selon la revendication 1, **caractérisé en ce qu'**il comporte une deuxième électrode de détection (D2) située à côté de la première électrode de détection (D1) et parallèle à la première électrode de détection, et des moyens de guidage de la lumière sous cette deuxième électrode de détection ainsi que des moyens de découplage optique et d'isolation électrique des zones de l'empilement (EM) situées sous les deux électrodes de détection.

3. Système de lecture optique d'un support d'enregistrement, **caractérisé en ce qu'**il comporte un dispositif émetteur-récepteur selon l'une des revendications précédentes, de telle façon que le dispositif émetteur-récepteur puisse émettre de la lumière vers un support d'enregistrement et des moyens de diffusion tels que de la lumière réfléchie par celui-ci soit transmise à au moins l'un des détecteurs.

4. Système selon la revendication 3, **caractérisé en ce qu'**il comporte un réseau de diffraction (RZ) destiné à être situé entre le dispositif émetteur-récepteur et le support d'enregistrement, transmettant la lumière qu'il reçoit du laser vers le support d'enregistrement et défléchissant la lumière qu'il reçoit du support d'enregistrement vers l'un au moins des détecteurs.

5. Système de lecture optique d'un support d'enregistrement **caractérisé en ce qu'**il comporte :
- une source laser émettant dans un faisceau lumineux de lecture ;
- au moins deux détecteurs optiques placés à côté de la source laser capable de détecter un faisceau lumineux sensiblement parallèle au faisceau incident de lecture ;
- un réseau de diffraction (RZ) destiné à être situé entre le dispositif émetteur-récepteur et le support d'enregistrement, transmettant au moins partiellement la lumière qu'il reçoit du laser vers le support d'enregistrement et défléchissant au moins partiellement la lumière qu'il reçoit du support d'enregistrement vers l'un au moins des détecteurs.

6. Système selon la revendication 5, **caractérisé en ce que** les deux détecteurs (DET1 et DET2) sont situés d'un même côté par rapport à la source laser (L).

7. Système selon l'une des revendications 4 ou 5, **caractérisé en ce que** le réseau de diffraction est sensiblement linéaire et qu'il ne donne lieu qu'à des ordres de diffraction d'un même signe (positifs par exemple).

8. Système selon la revendication 7, **caractérisé en ce que** chaque relief du réseau a une section crénelée présentant trois paliers, la distance entre le palier supérieur et le palier inférieur générant un déphasage sensiblement égal à 180° pour la longueur d'onde de fonctionnement.

9. Système selon la revendication 8, **caractérisé en ce que** le motif du réseau est tel que, le réseau ayant un pas déterminé, chaque relief présente une moitié de pas plane bordée de deux zones planes de largeurs égales à un quart du pas et déphasant la surface d'onde incidente de plus ou moins 90° par rapport à la partie centrale.

10. Système selon l'une des revendications 4 ou 5, **caractérisé en ce que** le réseau de diffraction comporte deux demi-réseaux (RZ1, RZ2) juxtaposés de pas différents, la limite de séparation (AB) des deux demi-réseaux étant orthogonale au sens de défilement d'information du support d'information et **en ce que** le dispositif émetteur-récepteur comporte un laser (L), un premier détecteur (DET1) et un deuxième détecteur (DET2) alignés selon une direction d'alignement perpendiculaire (ox) à la limite de séparation (AB) des deux réseaux.

11. Système selon la revendication 10, **caractérisé en ce que** les détecteurs (DET1, DET2) ont leur position décalée selon la direction d'alignement des détecteurs d'un même côté par rapport aux axes des faisceaux transmis par les deux demi-réseaux lorsque le système est focalisé.

12. Système selon la revendication 10, **caractérisé en ce que** les spots des faisceaux reçus par les détecteurs lorsque le système est focalisé sont situés de part et d'autre de la direction d'alignement des détecteurs.

13. Système selon l'une des revendications 4 ou 5, **caractérisé en ce que** le réseau de diffraction comporte deux demi-réseaux (RZ1, RZ2) juxtaposés de pas différents, la limite de séparation (AB) des deux demi-réseaux étant orthogonale au sens de défilement d'information du support d'information et **en ce que** le dispositif émetteur-récepteur comporte un laser (L), un premier détecteur (DET1) et un deuxième détecteur (DET2) alignés selon une direction d'aligment parallèle à la limite de séparation (AB) des deux réseaux.

14. Système selon la revendication 10, **caractérisé en ce que** les spots des faisceaux reçus par les détecteurs, lorsque le système est focalisé, sont situés d'un même côté par rapport à la direction d'alignement des détecteurs.

15. Système selon la revendication 10, **caractérisé en ce que** les spots des faisceaux reçus par les détecteurs, lorsque le système est focalisé, sont décalés selon la direction d'alignement des détecteurs, en sens inverses par rapport aux centres des détecteurs.

16. Système selon l'une des revendications 10 ou 13, **caractérisé en ce que** les stries d'indices des deux demi-réseaux font un angle différent de 90° avec la limite de séparation (AB) des deux demi-réseaux.

17. Système selon l'une des revendications 10 ou 13, **caractérisé en ce qu'**il comporte :
- un circuit d'addition (ADD) additionnant les signaux fournis par les détecteurs (DET1, DET2) ;
- un circuit de soustraction (SOU) soustrayant les signaux fournis par les détecteurs (DET1, DET2) ;
- un commutateur (C) connecté au circuit de soustraction, qui est mis dans une première position par le circuit d'addition (ADD) lorsque l'addition des signaux de détecteurs est supérieure à une première valeur déterminée et qui est mis dans une deuxième position par le circuit d'addition (ADD) lorsque l'addition des signaux des détecteurs est inférieure à une deuxième valeur ;
- un circuit de commande de focalisation connecté à la première position du commutateur, recevant la différence des signaux des détecteurs et agissant sur des circuits de commande de focalisation ;
- un circuit de commande de suivi de piste connecté à la deuxième position du commutateur, recevant la différence des signaux des détecteurs et agissant sur des circuits de commande de réglage de suivi de piste radial.

18. Système selon l'une des revendications précédentes, **caractérisé en ce que** le support d'enregistrement est un disque optique.

19. Dispositif émetteur-récepteur selon la revendication 1, **caractérisé en ce que** l'empilement est réalisé sur un substrat et **en ce que** la deuxième électrode d'injection de courant (E2) et la deuxième électrode de détection sont sur la même face du substrat qui porte l'empilement ou sur la face opposée.

20. Dispositif émetteur-récepteur selon la revendication 19, **caractérisé en ce que** la deuxième électrode d'injection de courant et la deuxième électrode de détection sont une même électrode.

## Patentansprüche

1. Optisches Lesesystem für einen Aufzeichnungsträger mit einer Sende- und Empfangsvorrichtung derart, daß diese Einrichtung Licht in Richtung auf einen Aufzeichnungsträger aussenden kann, und mit Diffusionsmitteln derart, daß vom Aufzeichnungsträger reflektiertes Licht an mindestens einen der Detektoren übertragen wird, wobei die Sende- und Empfangsvorrichtung für Licht einen Stapel (EM) von Schichten aus Halbleitermaterial enthält mit einer ersten und einer zweiten Elektrode (E1, E2) je an einer Seite des Stapels zur Einspeisung eines Stroms, die einen Betrieb des Stapels von Schichten im Lasermodus erlauben und die Emission eines Lichtstrahls an einer Schnittfläche des Stapels bewirken, wobei eine der Elektroden (E1) bandförmig ist, wobei weiter mindestens eine erste Detektorelektrode (D1) am Rand dieser Schnittfläche neben der bandförmigen Elektrode und an derselben Seite des Stapels wie diese angeordnet ist und einen Betrieb des Stapels zusammen mit einer zweiten, an der anderen Seite des Stapels liegenden Detektorelektrode (E2) im Photodetektormodus bewirkt, und wobei Mittel zur seitliche Führung des Lichts in den unter der Detektorelektrode (D1) und unter der bandförmigen Elektrode (E1) liegenden Zonen sowie Mittel zur gegenseitigen optischen Entkopplung und elektrischen Isolierung der unter diesen beiden Elektroden liegenden Zonen des Stapels (EM) vorhanden sind, und wobei schließlich ein Beugungsgitter (RZ) zwischen der Sende/Empfangsvorrichtung und dem Aufzeichnungsträger liegt, das das vom Laser empfangene Licht durchläßt und das vom Aufzeichnungsträger empfangene Licht in Richtung auf mindestens einen der Detektoren ablenkt und das im wesentlichen linear ist, einen Lichtdurchlaß gemäß der Beugungsordnung null besitzt und nur Beugungsordnungen eines gleichen Vorzeichens ergibt.

2. Optisches Lesesystem nach Anspruch 1, **dadurch gekennzeichnet, daß** die Sende- und Empfangsvorrichtung eine zweite Detektorelektrode (D2) neben der ersten Detektorelektrode (D1) und parallel zur ersten Detektorelektrode sowie Mittel zur Führung des Lichts unter die zweite Detektorelektrode sowie Mittel zur optischen Entkopplung und zur elektrischen Isolierung der Zonen des Stapels (EM) besitzt, die sich unter den beiden Detektorelektroden befinden.

3. System nach einem der Ansprüche 1 und 2, **dadurch gekennzeichnet, daß** die beiden Detektoren (DET1, DET2) bezüglich der Laserquelle (L) auf derselben Seite liegen.

4. System nach einem der Ansprüche 1 bis 3, **dadurch gekennzeichnet, daß** jedes Relief des Gitters einen gezackten Querschnitt mit drei Stufen besitzt, wobei der Abstand zwischen der obersten und der untersten Stufe eine Phasenverschiebung von im wesentliche 180° für die Betriebswellenlänge hervorruft.

5. System nach Anspruch 4, **dadurch gekennzeichnet, daß** das Motiv des Gitters so gewählt ist, daß es ein bestimmtes Rastermaß besitzt und jedes Relief eine ebene Zone mit halbe Rasterbreite zwischen zwei ebenen Zonen entsprechend einem Viertel des Rastermaßes besitzt, die die Wellenfront der ankommenden Lichtwelle bezüglich des zentralen Bereichs um +90° beziehungsweise -90° in der Phase verschiebt.

6. System nach einem der Ansprüche 1 bis 5, **dadurch gekennzeichnet, daß** das Beugungsgitter zwei nebeneinanderliegende Halbgitter (RZ1, RZ2) unterschiedlicher Rastermaße besitzt, daß die Trennlinie (AB) der beiden Halbgitter senkrecht zur Durchlaufrichtung der Information des Aufzeichnungsträgers verläuft und daß die Sende- und Empfangsvorrichtung einen Laser (L), einen ersten Detektor (DET1) und einen zweiten Detektor (DET2) in Flucht gemäß einer Fluchtungsrichtung (Ox) senkrecht zur Trennlinie (AB) der beiden Gitter enthält.

7. System nach Anspruch 6, **dadurch gekennzeichnet, daß** die Detektoren (DET1, DET2) gemäß der Fluchtungsrichtung der Detektoren auf einer Seite bezüglich der Achsen der von den beiden Halbgittern übertragenen Strahlen verschoben angeordnet sind, wenn das System fokussiert ist.

8. System nach Anspruch 6, **dadurch gekennzeichnet, daß** die Flecken der von den Detektoren empfangenen Strahlen zu beiden Seiten der Fluchtungsrichtung der beiden Detektoren liegen, wenn das System fokussiert ist.

9. System nach einem der Ansprüche 1 bis 5, **dadurch gekennzeichnet, daß** das Beugungsgitter zwei nebeneinanderliegende Halbgitter (RZ1, RZ2) unterschiedlicher Rastermaße besitzt, daß die Trennlinie (AB) der beiden Halbgitter senkrecht zur Durchlaufrichtung der Information des Aufzeichnungsträgers verläuft und daß die Sende- und Empfangsvorrichtung einen Laser (L), einen ersten Detektor (DET1) und einen zweiten Detektor (DET2) in Flucht gemäß einer Fluchtungsrichtung parallel zur Trennlinie (AB) der beiden Gitter enthält.

10. System nach Anspruch 6, **dadurch gekennzeichnet, daß** die Flecken der von den Detektoren empfangenen Strahlen auf einer Seite bezüglich der Fluchtungsrichtung der Detektoren liegen, wenn das System fokussiert ist.

11. System nach Anspruch 6, **dadurch gekennzeichnet, daß** die Flecken der von den Detektoren empfangenen Strahlen gemäß der Fluchtungsrichtung der Detektoren in umgekehrter Richtung bezüglich der Zentren der Detektoren versetzt sind, wenn das System fokussiert ist.

12. System nach einem der Ansprüche 6 und 9, **dadurch gekennzeichnet, daß** die Rasterlinien der beiden Halb-Gitter einen Winkel ungleich 90° mit der Trennlinie (AB) der beiden Halbgitter einschließen.

13. System nach einem der Ansprüche 6 und 9, **dadurch gekennzeichnet; daß** es aufweist:
- eine Addierschaltung (ADD), die die von den Detektoren (DET1, DET2) gelieferten Signale addiert,
- eine Subtraktionsschaltung (SOU), die die von den beiden Detektoren (DET1, DET2) gelieferten Signale voneinander subtrahiert,
- einen Schalter (C), der an die Subtraktionsschaltung angeschlossen ist und durch die Addierschaltung in eine erste Stellung gebracht wird, wenn die Addition der Detektorsignale größer als ein erster vorbestimmter Wert ist, sowie durch die Addierschaltung (ADD) in eine zweite Stellung gebracht wird, wenn die Summe der Signale der Detektoren kleiner als ein zweiter Wert ist,
- eine Fokussier-Steuerschaltung, die an die erste Stellung des Schalters angeschlossen ist und die Differenz der Signale der Detektoren empfängt sowie auf die Fokussiersteuerschaltungen einwirkt,
- eine Steuerschaltung für die Spurverfolgung, die an die zweite Stellung des Schalters angeschlossen ist und die Differenz der Signale der Detektoren empfängt und auf Steuerschaltungen zur radialen Spurverfolgung einwirkt.

14. Optisches System nach einem der vorstehenden Ansprüche, **dadurch gekennzeichnet, daß** der Aufzeichnungsträger eine optische Scheibe ist.

15. Optisches System nach einem der vorstehenden Ansprüche, **dadurch gekennzeichnet, daß** der Stapel der Sendevorrichtung auf einem Substrat liegt und daB die zweite Elektrode (E2) zur Stromeinspeisung sowie die zweite Detektorelektrode auf derselben Seite des Substrats sind, die den Stapel trägt, oder auf der entgegengesetzten Seite.

16. Optisches System nach Anspruch 15, **dadurch gekennzeichnet, daß** die zweite Elektrode zur Stromeinspeisung und die zweite Detektorelektrode von einer gemeinsamen Elektrode gebildet werden.

## Claims

1. Optical read system for a recording medium, comprising an emitter/receiver device such that the emitter/receiver device can emit light onto a recording medium and scattering means such that light reflected by the recording medium is transmitted to at least one of the detectors, the said light emitter/receiver device comprising a multilayer structure (MS) consisting of semiconductor materials having, on either side of the multilayer structure, first and second current injection electrodes (E1, E2) allowing the multilayer structure to operate in laser mode and emit a light beam via an edge face of the mulitlayer structure, one of the electrodes (E1) being in the form of a stripe, and having at least a first detection electrode (D1) placed at the edge of the said edge face alongside the said electrode in the form of a stripe and on the same side of the said multilayer structure as this electrode (E1), allowing the multilayer structure to operate in photodetector mode by cooperation with a second detection electrode (E2) placed on the other side of the multilayer structure (MS), and means for laterally guiding the light in the zones lying beneath the detection electrode (D1) and beneath the stripe-shaped electrode (E1) and means for optically decoupling and for electrically isolating the zones of the multilayer structure (MS) that lie beneath the two electrodes, and comprising a diffraction grating (DG) intended to be placed between the emitter/receiver device and the recording medium, transmitting the light that it receives from the laser onto the recording medium and deflecting the light that it receives from the recording medium onto at least one of the detectors, in which system the diffraction grating is substantially linear, exhibits zero-order transmission and gives rise only to diffraction orders of the same sign.

2. Optical read system according to Claim 1, **characterized in that** the emitter/receiver device includes a second detection electrode (D2) located beside the first detection electrode (D1) and parallel to the first detection electrode, and light-guiding means beneath this second detection electrode, and means for optically decoupling and electrically isolating the zones of the mulitlayer structure (MS) that lie beneath the two detection electrodes.

3. System according to either of Claims 1 and 2, **characterized in that** the two detectors (DET1 and DET2) lie on the same side with respect to the laser source (L).

4. System according to any one of Claims 1 to 3, **characterized in that** each relief of the grating has a crenelated cross section with three lands, the distance between the upper land and the lower land generating a phase shift of approximately 180° at the operating wavelength.

5. System according to Claim 4, **characterized in that** the pattern of the grating is such that, the grating having a defined period, each relief has a plane half-period bordered by two plane zones of widths equal to one quarter of the period and shifting the phase of the incident wave surface by plus or minus 90° relative to the central part.

6. System according to any one of Claims 1 to 5, **characterized in that** the diffraction grating comprises two juxtaposed half-gratings (DG1, DG2) of different periods, the separating boundary (AB) of the two half-gratings being orthogonal to the direction of movement of information of the information medium and **in that** the emitter/receiver device comprises a laser (L), a first detector (DET1) and a second detector (DET2) that are aligned in an direction of alignment (OX) perpendicular to the boundary (AB) that separates the two gratings.

7. System according to Claim 6, **characterized in that** the detectors (DET1, DET2) have their position offset in the direction of alignment of the detectors on one side relative to the axes of the beams transmitted by the two half-gratings when the system is focused.

8. System according to Claim 6, **characterized in that** the spots of the beams received by the detectors when the system is focused are located on either side of the direction of alignment of the detectors.

9. System according to any one of Claims 1 to 5, **characterized in that** the diffraction grating comprises two juxtaposed half-gratings (DG1, DG2) of different periods, the separating boundary (AB) of the two half-gratings being orthogonal to the direction of movement of information of the information medium and **in that** the emitter/receiver device comprises a laser (L), a first detector (DET1) and a second detector (DET2) that are aligned in an direction of alignment parallel to the boundary (AB) that separates the two gratings.

10. System according to Claim 6, **characterized in that** the spots of the beams received by the detectors when the system is focused are located on the same side relative to the direction of alignment of the detectors.

11. System according to Claim 6, **characterized in that** the spots of the beams received by the detectors, when the system is focused, are offset in the direction of alignment of the detectors in opposite directions relative to the centres of the detectors.

12. System according to either of Claims 6 and 9, **characterized in that** the index striations of the two half-gratings make an angle different from 90° with the boundary (AB) that separates the two half-gratings.

13. System according to Claim 6 or 9, **characterized in that** it includes:
- an addition circuit (ADD) that adds the signals delivered by the detectors (DET1, DET2);
- a subtraction circuit (SUB) that subtracts the signals delivered by the detectors (DET1, DET2);
- a switch (SW) connected to the subtraction circuit, which is placed in a first position by the addition circuit (ADD) when the addition of the signals from the detectors is greater than a first predetermined value and which is placed in a second position by the addition circuit (ADD) when the addition of the signals from the detectors is less than a second value;
- a focus control circuit connected to the first position of the switch, that receives the difference in the signals from the detectors and acts on focus control circuits; and
- a track-following control circuit connected to the second position of the switch, that receives the difference in the signals from the detectors and acts on control circuits for adjusting the radial track following.

14. System according to one of the preceding claims, **characterized in that** the recording medium is an optical disk.

15. Optical system according to one of the preceding claims, **characterized in that** the multilayer structure of the emitter device is made on a substrate an **in that** the second current injection electrode (E2) and the second detection electrode are on the same face of the substrate that carries the multilayer structure or on the opposite face.

16. Optical system according to Claim 15, **characterized in that** the second current injection electrode and the second detection electrode are one and the same electrode.
